# EUROPÄISCHE PATENTANMELDUNG

(11) **EP 0 762 817 A1**
(43) Veröffentlichungstag der Anmeldung: **12.03.1997**
(21) Anmeldenummer: 96114083.7
(22) Anmeldetag: 03.09.1996
(51) Int. Cl.: H05K 7/14, H05K 9/00

(54) **Abschirmung für Flachbaugruppen**

(30) Priorität: 07.09.1995 DE 29514398 U
(71) Anmelder: SIEMENS AKTIENGESELLSCHAFT, 80333 München (DE)
(72) Erfinder: Heiss, Reinhold, Dipl.-Ing., 85232 Deutenhausen (DE)

(57) **Zusammenfassung**

Zur Abschirmung von Flachbaugruppen mit Hochfrequenzbauelementen in Geräten der Nachrichtentechnik erstreckt sich die Schirmfläche nur über den Bereich der abzuschirmenden Bauelemente. Die Schirmfläche ist mit einer die Bauelemente umgebenden, Schirmpotential führenden Kontaktfläche auf der Leiterplatte elektrisch leitend verbunden.

## Beschreibung

Die vorliegende Erfindung betrifft eine Abschirmung für Flachbaugruppen mit Hochfrequenzbauelementen in Geräten der Nachrichtentechnik.

Die Hochfreqenzbaugruppen von Mobilfunkgeräten oder von Geräten mit vergleichbaren Anforderungen müssen gegen Störeinstrahlung und Störsendung geschirmt werden.

Bekannte Lösongen basieren auf gezielte Schirmmaßnahmen des Umfelds, z. B. der die Hochfrequenzbaugruppen umgebenden Gehäuseteile oder durch eigene Schirmteile. Nachteilig bei diesen Lösungen sind die aufwendigen elektrischen Kontaktierungen zwischen den geschirmten gehäuseteilen oder den Schirmteilen und den Kontaktflächen der zu schirmenden Flachbaugruppe. Ein weiterer Nachteil besteht darin, daß die Prüfung der Schirmfunktion während der Fertigung schwierig ist, da die Schirmung erst im montierten Zustand, d. h. beim Gesamtgerät zur Wirkung kommt. Für eine Prüfung in der Fertigungslinie müssen deshalb aufwendige sogenannte "Dummy-Lösungen" eingesetzt werden.

Aufgabe der vorliegenden Erfindung ist es, eine Abschirmung der eingangs genannten Art anzugeben, die fertigungstechnisch einfach durchzuführen ist und eine Prüfung während der Fertigung vor der Endmontage ermöglicht.

Diese Aufgabe wird für eine Abschirmung der eingangs genannten Art dadurch gelöst, daß sich die Schirmfläche nur über den Bereich der abzuschirmenden Bauelemente erstreckt und mit einer die Bauelemente umgebende, Schirmpotential führende Kontaktfläche auf der Leiterplatte elektrisch leitend verbunden ist.

Die erfindungsgemäße Abschirmung bietet den Vorteil, daß sich die Schirmungsmaßnahmen nur auf die eigentliche Baugruppe erstrecken. Dadurch ist eine einfache Fertigung der Abschirmung möglich. Gleichzeitig ist eine Überprüfung der Abschirmfunktion nach der Herstellung der einzelnen Baugruppe und vor der eigentlichen Endmontage möglich.

Eine zweckmäßige Ausgestaltung der Erfindung ist dadurch gekennzeichnet, daß die Schirmfläche aus einer Metallkaschierung einer tiefgezogenen Kunststoffolie besteht, wobei die mit dem leitfähigen Material kaschierte Kunststoffolie mit der Schirmpotential führenden Kontaktfläche der Leiterplatte verschweißt ist. Hierdurch ist es möglich, bei abzuschirmenden Baugruppen mit geichen Abmessungen eine Vorabfertigung der Abschirmung durchzuführen.

Eine andere zweckmäßige Ausgestaltung der Erfindung ist dadurch gekennzeichnet, daß die Schirmfläche aus einer leitende Oberfläche auf einer die Bauelemente und den zugehörigen Leiterplattenbereich abdeckenden nichtleitenden Schicht besteht, welche mit der Schirmpotential führenden Kontaktfläche der Leiterplatte elektrisch leitend verbunden ist. Bei dieser Ausgestaltung ist zwar eine Vorabfertigung der Abschirmung nicht möglich, dafür bietet diese Ausführung aber den Vorteil, daß der Raumbedarf für die Abschirmung auf ein minimum reduziert werden kann.

Weitere zweckmäßige Weiterbildungen der erfindungsgemäßen Abschirmung ergeben sich aus den weiteren Unteransprüchen, sowie aus der Beschreibung.

Nachfolgend wird die Erfindung anhand zweier in der Zeichnung dargestellter ausführungsbeispiele näher beschrieben.

Es zeigen
- FIG 1: eine erfindunggemäße Abschirmung unter Verwendung einer mit einem leitfähigen Material kaschierten Kunststofffolie, und
- FIG 2: eine erfindunggemäße Abschirmung unter Verwendung einer nichtleitenden Schicht mit einer leitenden Oberfläche.

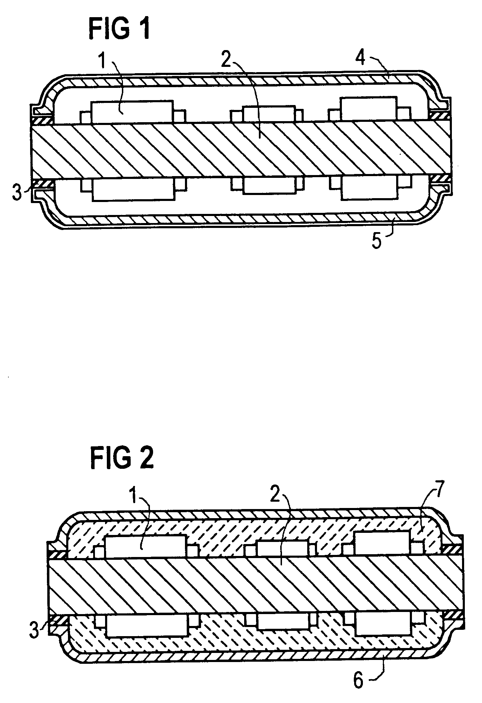

FIG 1 zeigt eine Abschirmung gemäß der vorliegenden Erfindung nach Anspruch 2. Auf einer Leiterplatte 2 sind Hochfrequenzbauelemte 1 und andere Bauelemente angeordnet, die auf einem Teil oder auf der gesamten Leiterplatte eine abzuschirmende Flachbaugruppe bilden.

Zur Abschirmung der Flachbaugruppe dient eine tiefgezogene und einseitig kaschierte Kunststoffolie 5. Als Schirmfläche 4 dient in diesem Fall die Metallkaschierung 4 der Kunststofffolie 5. Bei der Metallkaschierung 4 kann als Metall z. B. Kupfer, Silber, Gold usw. verwendet werden.

Die Metallkaschierung 4 wird z. B. mittels Ultraschweißen mit der Schirmpotential führenden Kontaktfläche 3 der Leiterplatte 2 elektrisch leitend verbunden. Bei der Schirmpotential führenden Kontaktfläche 3 kann es sich z. B. um eine die in Frage kommenden Bauelemente 1 umgebende Kontaktbahn handeln.

Bei dem hier beschriebenen Fall kann entsprechend weitergehenden Anforderungen die einseitige Kaschierung der Kunststofolie 5 auf der den Bauelementen 1 zugewandten Seite oder auf der den Bauelementen abgewandten Seite der Kunststoffolie 5 erfolgen.

FIG 2 zeigt eine Abschirmung gemäß der vorliegenden Erfindung nach Anspruch 3. Auch in diesem Fall sind auf einer Leiterplatte 2 Hochfrequenzbauelemte 1 und andere Bauelemente angeordnet, die auf einem Teil oder auf der gesamten Leiterplatte 2 eine abzuschirmende Flachbaugruppe bilden.

Bei diesem Ausführungsbeispiel wird die Schirmung dadurch erreicht, daß zuerst entweder eine dünne nichtleitende Schicht 7 aus z. B. Silikonkautschuk oder eine dünne nichtleitende Lackschicht aufgebracht wird. Diese nichtleitende Schicht 7 paßt sich den Konturen der Flachbaugruppe an. Anschließend wird die so ausgebildete Flachbaugruppe mit einer leitenden Oberfläche 6 beschichtet, z. B. metallisiert, wobei auch in diesem Fall durch das Beschichten die Kontaktierung mit der das Schirmpotential führenden Kontaktfläche 3 der Leiterplatte hergestellt wird.

Bei dem zuletzt beschriebenen Ausführungsbeispiel ist darauf zu achten, daß beim Aufbringen der nichtleitenden Schicht 7 die Schirmpotential führende Kontaktfläche 3 der Leiterplatte 2 freigehalten werden.

Die jeweiligen Vorteile und Nachteile der beiden Ausgestaltungen der erfindungsgemäßen Abschirmung sind bereits in der Beschreibungseinleitung aufgeführt worden.

## Patentansprüche

1. Abschirmung für Flachbaugruppen mit Hochfrequenzbauelementen in Geräten der Nachrichtentechnik,
**dadurch gekennzeichnet,**
daß sich die Schirmfläche (4, 6) nur über den Bereich der abzuschirmenden Bauelemente (1) erstreckt und mit einer die Bauelemente (1) umgebenden, Schirmpotential führenden Kontaktfläche (3) auf der Leiterplatte (2) elektrisch leitend verbunden ist.

2. Abschirmung nach Anspruch 1,
**dadurch gekennzeichnet,**
daß die Schirmfläche (4) aus einer Metallkaschierung einer tiefgezogenen Kunststoffolie (5) besteht, wobei die mit dem leitfähigen Material kaschierte Kunststoffolie (5) mit der Schirmpotential führenden Kontaktfläche (3) der Leiterplatte (3) verschweißt ist.

3. Abschirmung nach Anspruch 1,
**dadurch gekennzeichnet,**
daß die Schirmfläche (6) aus einer leitenden Oberfläche auf einer die Bauelemente (1) und den zugehörigen Leiterplattenbereich abdeckenden nichtleitenden Schicht (7) besteht, welche mit der Schirmpotential führenden Kontaktfläche (3) der Leiterplatte (2) elektrisch leitend verbunden ist.

4. Abschirmung nach Anspruch 3,
**dadurch gekennzeichnet,**
daß die nichtleitende Schicht (7) eine dünne Schicht aus Silikonkautschuk ist.

5. Abschirmung nach Anspruch 3,
**dadurch gekennzeichnet,**
daß die nichtleitende Schicht (7) eine dünne Lackschicht ist.
